# EUROPÄISCHE PATENTSCHRIFT

(11) **EP 3 149 807 B1**
(45) Veröffentlichungstag und Bekanntmachung des Hinweises auf die Patenterteilung: **08.07.2020**
(21) Anmeldenummer: 15727928.2
(22) Anmeldetag: 29.05.2015
(51) Int. Cl.: H01R 4/30, H01R 4/34, H01R 11/24

(54) **KONTAKTIERUNGSEINRICHTUNG UND VERFAHREN ZUM ELEKTRISCHEN KONTAKTIEREN EINES PRÜFOBJEKTS**
CONTACT-MAKING DEVICE AND METHOD FOR MAKING ELECTRICAL CONTACT WITH A TEST OBJECT
DISPOSITIF DE MISE EN CONTACT ET PROCÉDÉ DE MISE EN CONTACT ÉLECTRIQUE D'UN OBJET À CONTRÔLER

(30) Priorität: 02.06.2014 AT 503832014
(43) Veröffentlichungstag der Anmeldung: 05.04.2017
(73) Patentinhaber: Omicron electronics GmbH, 6833 Klaus (AT)
(72) Erfinder: KLAPPER, Ulrich, 6830 Rankweil (AT)
(74) Vertreter: Banzer, Hans-Jörg
(86) Internationale Anmeldenummer: PCT/EP2015/061988
(87) Internationale Veröffentlichungsnummer: WO 2015/185456

(56) Entgegenhaltungen:
- GB-A- 1 427 787
- US-A1- 2014 113 478

## Beschreibung

### GEBIET DER ERFINDUNG

Die Erfindung betrifft ein System, umfassend ein Messgerät, das zum Ausführen einer Widerstandsmessung mittels einer Vier-Punkt-Messung eingerichtet ist, eine Kontaktierungseinrichtung und eine weitere Kontaktierungseinrichtung zum elektrischen Kontaktieren eines Prüfobjekts nach Anspruch 1 sowie ein Verfahren zum elektrischen Kontaktieren eines Prüfobjekts für eine Widerstandsmessung nach Anspruch 14.

### HINTERGRUND

Viele elektrische Elemente müssen nach der Produktion oder später im Betrieb auf ihre elektrische Leitfähigkeit überprüft werden. Hierzu können Widerstandsmessungen ausgeführt werden. Typische Beispiele für derartige Messungen sind Widerstandsmessungen an Schaltern oder Trennern für Hochspannungsnetze oder Mittelspannungsnetze im geschlossenen Zustand.

Eine Messtechnik für eine Widerstandsmessung an derartigen Schaltern, die für hohe Ströme ausgelegt sind, ist die Mikroohmmessung. Bei der Mikroohmmessung wird ein Gleichstrom mit einer relativ großen Stromstärke, beispielsweise mit einer Stromstärke von 10 bis 1000 Ampere, durch das Prüfobjekt eingeprägt. Mittels separater Klemmen wird der Spannungsabfall über einem Abschnitt am Prüfobjekt gemessen.

Derartige Messtechniken, bei denen separate Messkontakte zum Einprägen des Stroms und zum Erfassen der abfallenden Spannung verwendet werden, werden auch als Vier-Punkt-Messungen bezeichnet. Derartige Methoden haben den Vorteil, dass Übergangswiderstände zwischen den Messkontakten und das Prüfobjekt nur einen geringen Einfluss auf den gemessenen Widerstand haben. Bei den Kontakten, die zum Aufprägen des Stroms verwendet werden, spielt der Widerstand keine Rolle, weil sich dadurch lediglich die benötigte treibende Spannung an der Stromquelle erhöht. Dies hat jedoch keinen Einfluss auf die gemessene Spannung. Bei den Kontakten, über die die Spannung gemessen wird, fließt nur ein geringer Strom, da das Spannungsmessgerät hochohmig ist. Daher entsteht auch an den Spannungsklemmen kein signifikanter Spannungsabfall, der die gemessene Spannung verfälschen würde.

Der räumliche Bereich, für den die darüber abfallende Spannung gemessen wird, ist durch die Position der Kontakte definiert, die zur Spannungsmessung an dem Prüfobjekt angebracht werden. Bei zahlreichen Prüfobjekten in der Energietechnik, wie beispielsweise Hochspannungsschaltern, sind die Bereiche, an denen die Kontakte zur Messung angebracht werden, massive Metallteile mit hoher Leitfähigkeit. Die relevanten Widerstände ergeben sich beispielsweise an Schraubstellen, Stoß- oder Klemmstellen oder Schaltkontakte von geschlossenen Schaltern oder Trennern. Die exakten Positionen, an denen die Kontakte angebracht werden, beeinflussen das Messergebnis der Widerstandsmessung nicht wesentlich. Sehr wichtig ist jedoch, die Kontaktierung für den Strompfad und die Kontaktierung für den Spannungspfad sauber zu trennen.

Bei manchen Prüfobjekten kann ein Anschlusspunkt vorhanden sein, der über ein Innengewinde verfügt. An einen derartigen Anschlusspunkt kann im Normalbetrieb ein guter elektrischer Leiter angeschlossen sein. Der Anschlusspunkt weist jedoch häufig kleine Abmessungen auf. Dies macht es schwierig, die Kontaktierung für den Strompfad und die Kontaktierung für den Spannungspfad sauber zu trennen, wenn ein Kontakt für den Strompfad und ein Kontakt für den Spannungspfad an dem Anschlusspunkt angebracht werden sollen.

### ZUSAMMENFASSUNG

Ausführungsbeispielen der Erfindung liegt die Aufgabe zugrunde, eine sichere und einfache elektrische Kontaktierung eines Prüfobjekts für eine Widerstandsmessung zu ermöglichen, wenn das Prüfobjekt ein Gewindeloch mit einem Innengewinde aufweist. Insbesondere ist es wünschenswert, ein derartiges Prüfobjekt, beispielsweise einen Schalter oder Trenner für Hochspannungsnetze oder Mittelspannungsnetze, so elektrisch zu kontaktieren, dass an dem Anschlusspunkt sowohl ein Kontakt für den Strompfad als auch ein Kontakt für den Spannungspfad an dem Anschlusspunkt zuverlässig angebracht werden kann.

Nach Ausführungsbeispielen wird eine Kontaktierungseinrichtung für eine Widerstandsmessung bereitgestellt, die für ein Prüfobjekt, das ein Gewindeloch mit einem Innengewinde umfasst, verwendbar ist. Die Kontaktierungseinrichtung ist so ausgestaltet, dass sie mechanisch an dem Innengewinde fixierbar ist. Dazu kann die Kontaktierungseinrichtung für einen Gewindeeingriff mit dem Innengewinde des Prüfobjekts ausgestaltet sein. Alternativ oder zusätzlich kann die Kontaktierungseinrichtung Zähne aufweisen, die mit wenigstens einem Gewindegang des Innengewindes in Eingriff treten kann. Die Kontaktierungseinrichtung weist einen ersten Kontakt und einen zweiten Kontakt auf. Der erste Kontakt und der zweite Kontakt sind in der Kontaktierungseinrichtung elektrisch voneinander isoliert. Der erste Kontakt und der zweite Kontakt können in der Kontaktierungseinrichtung mechanisch miteinander verbunden sein, um eine gemeinsame und einfache Installation zu ermöglichen. Der erste Kontakt und der zweite Kontakt sind so angeordnet, dass sie das Prüfobjekt an unterschiedlichen Positionen elektrisch kontaktieren, wenn die Kontaktierungseinrichtung mit dem Innengewinde mechanisch gekoppelt ist.

Die Kontaktierungseinrichtung kann als eine Klemme ausgestaltet sein. Die Kontaktierungseinrichtung kann als ein elektrischer Verbinder ausgestaltet sein. Die Kontaktierungseinrichtung kann schraubenförmig ausgestaltet sein.

Durch den ersten Kontakt und den zweiten Kontakt können sowohl eine Kontaktierung für den Spannungspfad als auch eine Kontaktierung für den Strompfad einer Vier-Punkt-Messung hergestellt werden. Dazu muss nur die Kontaktierungseinrichtung in Eingriff mit dem Innengewinde des Prüfobjekts gebracht werden. Der benötigte weitere Kontakt für den Spannungspfad und der weitere Kontakt für den Strompfad können beispielsweise unter Verwendung einer weiteren Kontaktierungseinrichtung nach einem Ausführungsbeispiel oder durch herkömmliche Kontaktklemmen, die mit dem Prüfobjekt verbunden werden, erzielt werden.

Die Kontaktierungseinrichtung kann temporär oder permanent mit dem Innengewinde des Prüfobjekts verbunden werden.

Wenigstens einer von dem ersten Kontakt und dem zweiten Kontakt kann einen Vorsprung aufweisen, der für einen Eingriff mit dem Innengewinde eingerichtet ist. Der Vorsprung kann für einen formschlüssigen Eingriff mit dem Innengewinde eingerichtet sein. Dadurch kann die Kontaktierungseinrichtung sicher an dem Prüfobjekt befestigt werden. Der Vorsprung kann für eine reibschlüssige Verbindung mit dem Innengewinde eingerichtet sein.

Die Kontaktierungseinrichtung kann so ausgestaltet sein, dass in dem Zustand, in dem die Kontaktierungseinrichtung an dem Innengewinde des Prüfobjekts angebracht ist, der erste Kontakt und der zweite Kontakt beide an einer Oberfläche des Prüfobjekts anliegen, die von einer Innenoberfläche des Gewindelochs verschieden ist.

Die Kontaktierungseinrichtung kann so ausgestaltet sein, dass in dem Zustand, in dem die Kontaktierungseinrichtung an dem Innengewinde des Prüfobjekts fixiert ist, der erste Kontakt an der Innenoberfläche des Gewindelochs anliegt und das Prüfobjekt dort elektrisch kontaktiert, und dass der zweite Kontakt an einer Oberfläche des Prüfobjekts anliegt, die von einer Innenoberfläche des Gewindelochs verschieden ist.

Die Kontaktierungseinrichtung kann so ausgestaltet sein, dass in dem Zustand, in dem die Kontaktierungseinrichtung an dem Innengewinde des Prüfobjekts fixiert ist, der erste Kontakt und der zweite Kontakt an unterschiedlichen Bereichen der Innenoberfläche des Gewindelochs anliegen.

Eine Kontaktierungseinrichtung zum elektrischen Kontaktieren eines Prüfobjekts, das ein Gewindeloch mit Innengewinde umfasst, ist für eine mechanische Kopplung mit dem Innengewinde des Gewindelochs eingerichtet. Die Kontaktierungseinrichtung umfasst einen ersten Kontakt und einen zweiten Kontakt, um das Prüfobjekt an wenigstens zwei Stellen elektrisch zu kontaktieren, wenn die Kontaktierungseinrichtung mit dem Innengewinde des Gewindelochs mechanisch gekoppelt ist. Der erste Kontakt und der zweite Kontakt sind in der Kontaktierungseinrichtung durch ein isolierendes Material elektrisch voneinander isoliert.

Die Kontaktierungseinrichtung kann einen Schraubenabschnitt aufweisen, der in das Gewindeloch des Prüfobjekts einschraubbar ist. Die Kontaktierungseinrichtung kann schraubenförmig sein. Dadurch ist die Kontaktierungseinrichtung zum Herstellen einer leitfähigen Verbindung für einen Strompfad und einer leitfähigen Verbindung für einen Spannungspfad in einfacher Weise an dem Prüfobjekt fixierbar.

Die Kontaktierungseinrichtung kann ein Außengewinde aufweisen. Das Außengewinde kann an dem Schraubenabschnitt vorgesehen sein. Das Außengewinde kann für einen Gewindeeingriff mit dem Gewindeloch des Prüfobjekts ausgestaltet sein. Das Außengewinde kann wenigstens einen Gewindegang umfassen. Eine Ganghöhe des wenigstens einen Gewindegangs des Außengewindes kann gleich einer Ganghöhe des Innengewindes sein. Ein Durchmesser des Außengewindes kann an einen Durchmesser des Innengewindes angepasst sein.

Der erste Kontakt und der zweite Kontakt können in der Kontaktierungseinrichtung elektrisch von dem Schraubenabschnitt isoliert sind. Dadurch kann eine Kontaktierung an anderen Stellen des Prüfobjekts als der Innenoberfläche des Gewindelochs einfach erreicht werden.

Der erste Kontakt und der zweite Kontakt können so an der Kontaktierungseinrichtung angeordnet sein, dass sie von einer Innenoberfläche des Gewindelochs beabstandet sind, wenn die Kontaktierungseinrichtung mit dem Innengewinde des Gewindelochs mechanisch gekoppelt ist. Die Kontakte können dann durch den Schraubenabschnitt mechanisch in ihrer Position gehalten, während die Kontaktierung für den Strompfad und die Kontaktierung für die Spannungsmessung außerhalb des Gewindelochs erfolgt.

Der erste Kontakt kann einen Schraubenform aufweisen und so den Schraubenabschnitt bilden. Dadurch kann der erste Kontakt das Prüfobjekt an der Innenoberfläche des Gewindelochs elektrisch leitend kontaktieren. Da der Schraubenabschnitt robust ausgebildet sein kann, stellt er einen guten elektrischen Kontakt beispielsweise für den Strompfad einer Vier-Punkt-Messung dar.

Der zweite Kontakt kann so an der Kontaktierungseinrichtung angeordnet sein, dass er von einer Innenoberfläche des Gewindelochs beabstandet ist, wenn die Kontaktierungseinrichtung mit dem Innengewinde des Gewindelochs mechanisch gekoppelt ist. Dadurch kann eine sichere Trennung der Kontaktierung für den Strompfad und der Kontaktierung für die Spannungsmessung auch dann erfolgen, wenn der in das Gewindeloch eingeschraubte Schraubenabschnitt selbst den ersten Kontakt bildet.

Die Kontaktierungseinrichtung kann so ausgestaltet sein, dass sowohl der erste Kontakt als auch der zweite Kontakt in dem Gewindeloch angeordnet sind und an unterschiedlichen Bereichen der Innenoberfläche des Gewindelochs anliegen, wenn die Kontaktierungseinrichtung mit dem Innengewinde mechanisch gekoppelt ist. Hierfür kann der Schraubenabschnitt, der in das Gewindeloch eingeschraubt werden kann, sowohl den ersten Kontakt als auch den zweiten Kontakt umfassen. Dies erlaubt eine besonders kompakte Ausgestaltung der Kontaktierungseinrichtung.

Der erste Kontakt kann einen Abschnitt wenigstens eines Gewindegangs aufweisen, und der zweite Kontakt kann einen weiteren Abschnitt des wenigstens einen Gewindegangs aufweisen. Dadurch kann an der Kontaktierungseinrichtung ein Außengewinde gebildet werden, das eine sichere Verankerung in dem Gewindeloch erlaubt, wenn der erste Kontakt und der zweite Kontakt beide in das Gewindeloch eingeschraubt werden.

Der Schraubenabschnitt kann durch das elektrisch isolierende Material in den ersten Kontakt und den zweiten Kontakt unterteilt sein. Das elektrisch isolierende Material kann sich in einer Ebene zwischen den Hälften des Schraubenabschnitts erstrecken, die den ersten Kontakt und den zweiten Kontakt bilden. Das elektrisch isolierende Material kann sich vollständig zwischen entgegengesetzten Enden des Schraubenabschnitts erstrecken, um den ersten Kontakt und den zweiten Kontakt gegeneinander elektrisch zu isolieren.

Wenigstens einer von dem ersten Kontakt und dem zweiten Kontakt kann ein gefederter Kontakt sein. Der gefederte Kontakt kann für einen Eingriff mit dem Innengewinde eingerichtet sein.

Der erste Kontakt kann ein erster Backen einer Klemme sein, und der zweite Kontakt kann ein zweiter Backen einer Klemme sein. Der erste Kontakt und der zweite Kontakt können gegeneinander beweglich sein.

Die Kontaktierungseinrichtung kann ein Druckelement umfassen, das den ersten Kontakt und den zweiten Kontakt federnd voneinander weg drückt.

Der erste Kontakt und der zweite Kontakt können jeweils Zähne für einen Eingriff mit dem Innengewinde des Prüfobjekts aufweisen. Die Zähne des ersten Kontakts und die Zähne des zweiten Kontakts können jeweils an voneinander weg zeigenden Außenseiten der Kontaktierungseinrichtung angeordnet sein.

Ein Abstand zwischen benachbarten Zähnen des ersten Kontakts kann einer Ganghöhe des Innengewindes entsprechen. Ein Abstand zwischen benachbarten Zähnen des zweiten Kontakts kann der Ganghöhe des Innengewindes entsprechen.

Die Kontaktierungseinrichtung, die als Klemme ausgebildet ist, kann im Gebrauch in das Gewindeloch eingeführt werden. Das Druckelement kann die Zähne des ersten Kontakts und die Zähne des zweiten Kontakts in Eingriff mit dem Innengewinde drücken, um die Kontaktierungseinrichtung an dem Prüfobjekt zu fixieren.

Ein System nach der Erfindung umfasst ein Messgerät, das zum Ausführen einer Widerstandsmessung eingerichtet ist. Das System umfasst eine Kontaktierungseinrichtung nach einem Ausführungsbeispiel. Der erste Kontakt und der zweite Kontakt der Kontaktierungseinrichtung können elektrisch leitend mit dem Messgerät verbunden sein.

Der erste Kontakt der Kontaktierungseinrichtung kann mit einer Stromquelle des Messgeräts verbunden sein. Der zweite Kontakt der Kontaktierungseinrichtung kann mit einer Spannungsmesseinrichtung des Messgeräts verbunden sein.

Das Messgerät ist eingerichtet um eine Vier-Punkt-Messung für eine Widerstandsmessung auszuführen.

Das System umfasst erfindungsgemäß eine weitere Kontaktierungseinrichtung. Der erste Kontakt und der zweite Kontakt der weiteren Kontaktierungseinrichtung können elektrisch leitend mit dem Messgerät verbunden sein. Der erste Kontakt der weiteren Kontaktierungseinrichtung kann mit der Stromquelle des Messgeräts verbunden sein. Der zweite Kontakt der weiteren Kontaktierungseinrichtung kann mit der Spannungsmesseinrichtung des Messgeräts verbunden sein.

Das System kann ein Prüfobjekt mit einem Gewindeloch umfassen. Das Gewindeloch kann ein Innengewinde aufweisen. Die Kontaktierungseinrichtung kann mechanisch mit dem Innengewinde des Prüfobjekts gekoppelt sein.

Bei einem Verfahren zum elektrischen Kontaktieren eines Prüfobjekts für eine Widerstandsmessung umfasst das Prüfobjekt ein Gewindeloch, das ein Innengewinde aufweist. Eine Kontaktierungseinrichtung wird mit dem Innengewinde des Gewindelochs mechanisch gekoppelt, um das Prüfobjekt für die Widerstandsmessung mit einem ersten Kontakt der Kontaktierungseinrichtung und mit einem zweiten Kontakt der Kontaktierungseinrichtung an wenigstens zwei Stellen elektrisch zu kontaktieren. Der erste Kontakt und der zweite Kontakt sind in der Kontaktierungseinrichtung durch ein elektrisch isolierendes Material elektrisch voneinander isoliert.

Bei dem Verfahren kann über den ersten Kontakt ein Strom in das Prüfobjekt eingeprägt werden. Der zweite Kontakt kann für eine Spannungsmessung verwendet werden.

Das Verfahren kann mit der Kontaktierungseinrichtung oder dem System nach einem Ausführungsbeispiel ausgeführt werden.

Weitere Merkmale des Verfahrens nach Ausführungsbeispielen und die damit jeweils erzielten Wirkungen entsprechen den unter Bezugnahme auf die Kontaktierungseinrichtung und das System beschriebenen Merkmale und Wirkungen.

Das Prüfobjekt kann ein Element der Energietechnik sein. Das Prüfobjekt kann ein Schalter oder Trenner für ein Hochspannungs- oder Mittelspannungsnetz sein. Das Prüfobjekt kann ein Leistungsschalter, ein Leistungstrennschalter, ein Lastschalter, ein Lasttrennschalter, ein Trenner oder ein Erdungstrennschalter sein. Bei Systemen und Verfahren nach Ausführungsbeispielen kann die Kontaktierungseinrichtung für eine Widerstandsmessung verwendet werden, mit der der Widerstand eines Stoß- oder Klemmstelle des Prüfobjekts, beispielsweise eines Hochspannungsschalters, gemessen wird.

Kontaktierungseinrichtungen, Systeme und Verfahren nach Ausführungsbeispielen erlauben in einfacher Weise, eine elektrische Kontaktierung für einen Strompfad und eine elektrische Kontaktierung für eine Spannungsmessung einer Vier-Punkt-Messung herzustellen.

### KURZE BESCHREIBUNG DER FIGUREN

Die Erfindung wird nachfolgend unter Bezugnahme auf die Zeichnungen anhand bevorzugter Ausführungsformen näher erläutert. In den Zeichnungen bezeichnen identische Bezugszeichen ähnliche oder identische Elemente.
Figur 1 ist eine Schnittansicht einer Kontaktierungseinrichtung nach einem Ausführungsbeispiel, die mechanisch mit einem Prüfobjekt gekoppelt ist.
Figur 2 ist eine Schnittansicht einer Kontaktierungseinrichtung nach einem weiteren Ausführungsbeispiel, die mechanisch mit einem Prüfobjekt gekoppelt ist.
Figur 3 ist eine Schnittansicht einer Kontaktierungseinrichtung nach einem weiteren Ausführungsbeispiel, die mechanisch mit einem Prüfobjekt gekoppelt ist.
Figur 4 ist eine Schnittansicht einer Kontaktierungseinrichtung nach einem weiteren Ausführungsbeispiel, die mechanisch mit einem Prüfobjekt gekoppelt ist.
Figur 5 zeigt ein System nach einem Ausführungsbeispiel.
Figur 6 zeigt ein System nach einem weiteren Ausführungsbeispiel.

### DETAILLIERTE BESCHREIBUNG VON AUSFÜHRUNGSBEISPIELEN

Nachfolgend werden Ausführungsbeispiele unter Bezugnahme auf die Figuren detailliert beschrieben. Die Merkmale der verschiedenen Ausführungsbeispiele können miteinander kombiniert werden, sofern dies in der nachfolgenden Beschreibung nicht ausdrücklich ausgeschlossen ist. Auch wenn einige Ausführungsbeispiele im Kontext spezifischer Messmethoden zur Widerstandsmessung und/oder im Kontext spezifischer Prüfobjekte beschrieben werden, sind die Ausführungsbeispiele nicht hierauf beschränkt.

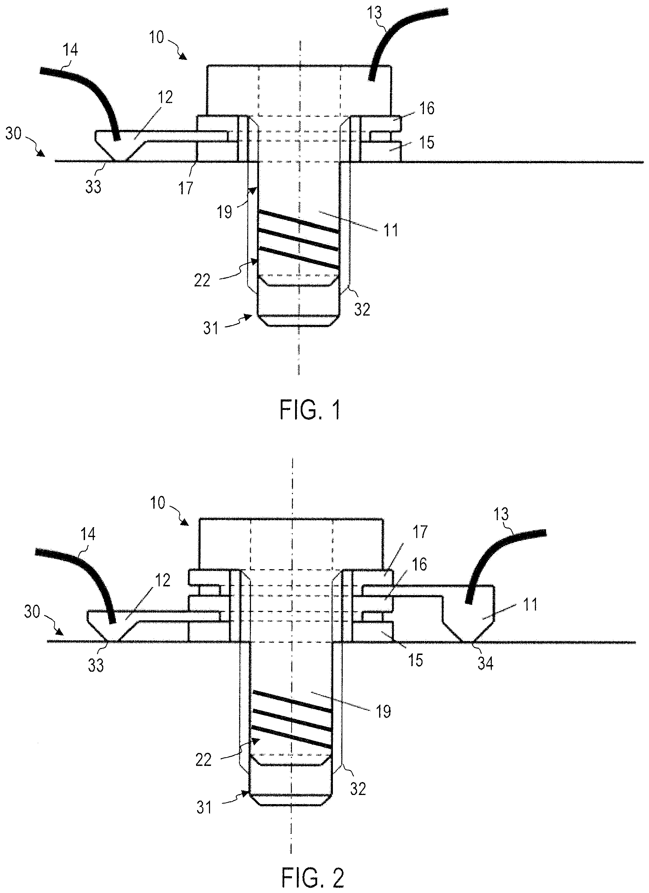

Figur 1 zeigt eine Schnittansicht eines Systems mit einem Prüfobjekt 30 und einer Kontaktierungseinrichtung 10 nach einem Ausführungsbeispiel. Das Prüfobjekt 30 kann ein Hochspannungsschalter oder ein anderes Element der Energietechnik sein. Das Prüfobjekt 30 weist ein Gewindeloch 31 auf. Wenigstens ein Teil einer Innenoberfläche des Gewindelochs 31 ist mit einem Innengewinde 32 versehen.

Die Kontaktierungseinrichtung 10 ist eingerichtet, um an dem Innengewinde 32 befestigt zu werden. Die Kontaktierungseinrichtung 10 weist einen ersten Kontakt 11 und einen zweiten Kontakt 12 auf, um das Prüfobjekt 30 an dem das Gewindeloch 32 umgebenden Metall elektrisch zu kontaktieren. Eine elektrische Leitung 13 kann den ersten Kontakt 11 mit einem Messgerät verbinden. Das Messgerät kann eine Stromquelle umfassen, die über den ersten Kontakt 11 und einen (in Figur 1 nicht dargestellten) anderen Kontakt eine Spannungsmessung ausführt einen Gleichstrom in das Prüfobjekt 30 aufprägen kann. Eine elektrische Leitung 14 kann den zweiten Kontakt 12 mit dem Messgerät verbinden. Das Messgerät kann eine Spannungsmesseinrichtung umfassen, die über den zweiten Kontakt 12 und einen (in Figur 1 nicht dargestellten) weiteren Kontakt eine Spannungsmessung ausführt.

Die Kontaktierungseinrichtung 10 weist einen Schraubenabschnitt 19 auf, der in einen Gewindeeingriff mit dem Gewindeloch 31 gebracht werden kann. Der Schraubenabschnitt 19 dient dabei selbst als der erste Kontakt, über den der Gleichstrom beispielsweise an der Innenoberfläche des Gewindelochs 31 dem Prüfobjekt 30 aufgeprägt werden kann. Der Schraubenabschnitt 19 kann als zylinderförmiger Bolzen mit einem Außengewinde 22 ausgebildet sein oder kann einen derartigen zylinderförmigen Bolzen mit dem Außengewinde 22 umfassen. Das Außengewinde 22 weist wenigstens einen Gewindegang mit einer Ganghöhe auf, die der Ganghöhe des Innengewindes 32 entspricht. Der Außendurchmesser des Außengewindes 22 ist so an den Innendurchmesser des Gewindelochs 31 angepasst, dass die Kontaktierungseinrichtung in das Gewindeloch 31 eingeschraubt und dort durch den Gewindeeingriff fixiert werden kann.

Bei der Kontaktierungseinrichtung 10 von Figur 1 ist der zweite Kontakt 12 so angeordnet, dass er sich vollständig außerhalb des Gewindelochs 31 befindet, wenn die Kontaktierungseinrichtung 10 durch den Gewindeeingriff an dem Prüfobjekt 30 befestigt ist. Durch ein elektrisch isolierendes Material, beispielsweise durch Isolierscheiben 15, 16, 17, kann der zweite Kontakt 12 von dem ersten Kontakt 11 elektrisch isoliert sein. Der zweite Kontakt 12 kann sich in satter Anlage an einer Stelle 33 des Prüfobjekts 30 befinden, wenn der Schraubenabschnitt 19 in das Gewindeloch 10 geschraubt wird, um die Kontaktierungseinrichtung 10 mechanisch an dem Prüfobjekt 10 zu befestigen.

Bei der Kontaktierungseinrichtung 10, die in Figur 1 dargestellt ist, dient der Schraubenabschnitt 19 selbst als der erste Kontakt. Dies erlaubt beispielsweise das Aufprägen eines Stroms für eine Vier-Punkt-Widerstandsmessung über die Innenoberfläche des Gewindelochs 31 aufzuprägen. Der zweite Kontakt 12 kann an einer Stelle 33 des Prüfobjekts 30 anliegen und kann von der Kontaktierungseinrichtung 10 gegen die Stelle 33 gedrückt werden, die das Gewindeloch nicht unmittelbar begrenzt.

Die Kontaktierungseinrichtung 10 mit dem Schraubenabschnitt 19, der auch als erster Kontakt 11 dient, dem zweiten Kontakt 12 und dem isolierenden Material 15, 16, 17 kann als integrale Einheit ausgebildet sein, d.h. als ein Kontaktierungselement, das an dem Prüfobjekt 30 befestigt werden kann, um den ersten Kontakt 11 und den zweiten Kontakt 12 in Anlage mit dem Prüfobjekt 30 zu bringen.

Figur 2 zeigt ein System mit einer Kontaktierungseinrichtung 10 nach einem weiteren Ausführungsbeispiel. Bei der Kontaktierungseinrichtung 10 dient der Schraubenabschnitt 19 mit dem Außengewinde 22 nur zur mechanischen Befestigung der Kontaktierungseinrichtung 10 an dem Prüfobjekt 30.

Der erste Kontakt 11 ist über ein isolierendes Material, beispielsweise Isolierscheiben 15, 16, 17, von dem Schraubenabschnitt 19 und dem zweiten Kontakt 12 elektrisch isoliert. Die Kontaktierungseinrichtung 10 ist eingerichtet, um den ersten Kontakt 11 gegen einen Abschnitt des Prüfobjekts 30 zu drücken, der von der Innenoberfläche des Gewindelochs beabstandet ist. Der zweite Kontakt 12 ist, wie unter Bezugnahme auf Figur 1 beschrieben, durch ein isolierendes Material gegen den Schraubenabschnitt 19 isoliert. Entsprechend wirkt der Schraubenabschnitt 19 selbst nicht als Kontakt, über den Strom eingeprägt oder ein Potenzial für eine Spannungsmessung abgegriffen wird. Der Schraubenabschnitt 19 kann auch selbst aus einem isolierenden Material bestehen.

Wie in Figur 2 dargestellt, können der erste Kontakt 11 und der zweite Kontakt 12 beispielsweise in entgegengesetzten Richtungen von dem Schraubenabschnitt 19 abstehen. Andere Geometrien können verwendet werden.

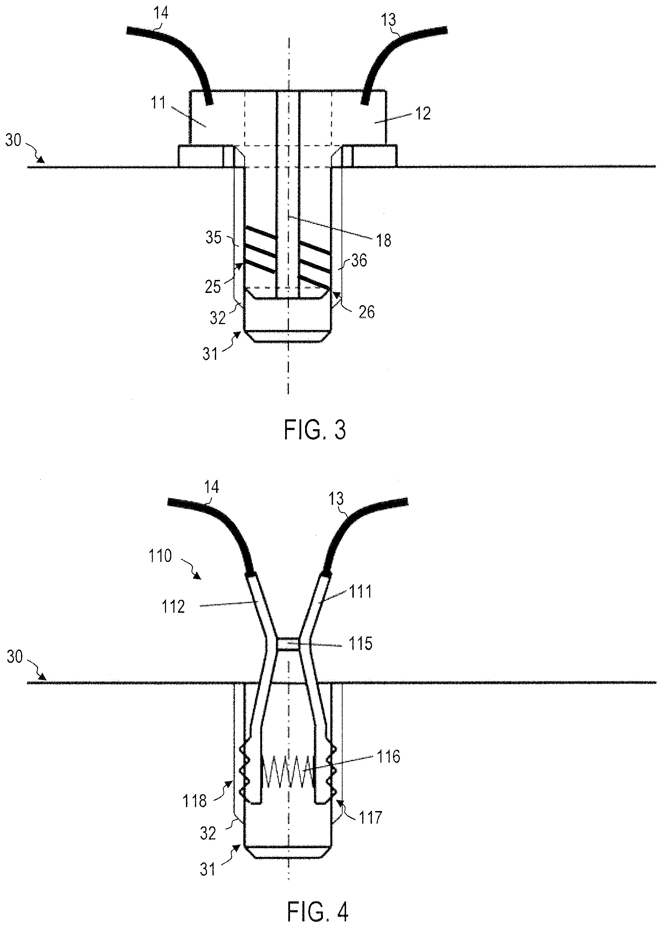

Figur 3 zeigt ein System mit einer Klemmeinrichtung 10, die in einer Schraubenform ausgeführt ist. Die Klemmeinrichtung 10 wird durch einen ersten Kontakt 11, einen zweiten Kontakt 12 und eine dazwischen angeordnete isolierende Schicht 18.

Wenn die Klemmeinrichtung 10 in Gewindeeingriff mit dem Innengewinde 32 des Gewindelochs 31 gebracht ist, erstrecken sich der erste Kontakt 11 und der zweite Kontakt 12 in das Gewindeloch 31. Der erste Kontakt 11 liegt an einem Bereich 35 der Innenoberfläche des Gewindelochs 31 an. An dem Bereich 35 kann über den ersten Kontakt 11 beispielsweise ein Strom in das Prüfobjekt 30 aufgeprägt werden. Der zweite Kontakt 12 liegt an einem weiteren Bereich 36 der der Innenoberfläche des Gewindelochs 31 an. An dem weiteren Bereich 36 kann über den zweiten Kontakt 12 beispielsweise ein Potenzial für eine Spannungsmessung mit der Vier-Punkt-Methode erfasst werden.

Für eine sichere Fixierung der Kontaktierungseinrichtung 10 an dem Innengewinde 32 des Gewindelochs 31 kann sich wenigstens ein Gewindegang entlang des ersten Kontakts 11 und entlang des zweiten Kontakts 12 erstrecken. Ein Abschnitt 25 eines Gewindegangs kann an dem ersten Kontakt 11 ausgebildet sein. Der Gewindegang kann einen weiteren Abschnitt 26 aufwesen, der an dem zweiten Kontakt 12 ausgebildet ist. Die Abschnitte 25, 26 des Gewindegangs sind eingerichtet, um mit einem Gewindegang des Innengewindes 31 in Eingriff zu treten. Die Abschnitte 25, 26 des Gewindegangs weisen dieselbe Gewindesteigung auf.

Der Teil des ersten Kontakts 11, der sich im installierten Zustand in dem Gewindeloch 31 befindet, kann die Form eines Zylinderabschnitts aufweisen. Der Teil des zweiten Kontakts 32, der sich im installierten Zustand in dem Gewindeloch 31 befindet, kann ebenfalls die Form eines Zylinderabschnitts aufweisen. Beispielsweise können die Teile des ersten Kontakts 11 und des zweiten Kontakts 12 Zylinderabschnitte sein, deren Grundfläche kleiner als der Halbkreis ist. Die isolierende Schicht 18 kann sich zwischen dem ersten Kontakt 11 und dem zweiten Kontakt 12 erstrecken. Die isolierende Schicht 18 kann sich entlang einer Mittelachse der Kontaktierungseinrichtung 10 erstrecken.

Eine Kontaktierungseinrichtung 10, wie sie unter Bezugnahme auf Figur 3 erläutert wurde, kann vorteilhaft auch dann verwendet werden, wenn der Anschlusspunkt des Prüfobjekts 30 klein ist. Beispielsweise kann die Kontaktierungseinrichtung 10, die unter Bezugnahme auf Figur 3 erläutert wurde, auch dann verwendet werden, wenn nur ein kleiner ringförmiger Bereich um das Gewindeloch 31 für die elektrische Kontaktierung zur Verfügung steht.

Figur 4 zeigt ein System mit einer Kontaktierungseinrichtung 110 nach einem weiteren Ausführungsbeispiel.

Die Kontaktierungseinrichtung 110 ist als eine Klemme ausgestaltet. Die Kontaktierungseinrichtung 110 weist einen ersten Kontakt 111 auf, der als einer der Backen der Klemme ausgebildet ist. Die Kontaktierungseinrichtung 110 weist einen zweiten Kontakt 112 auf, der als ein weiterer Backen der Klemme ausgebildet ist.

Der erste Kontakt 111 weist an einer Seite, die von dem zweiten Kontakt 112 abgewandt ist, einen Zahn oder mehrere Zähne 117 auf. Der zweite Kontakt 112 weist an einer Seite, die von dem ersten Kontakt 111 abgewandt ist, einen Zahn oder mehrere Zähne 118 auf. Eine Größe jedes Zahns der Zähne 117, 118 und ein Abstand zwischen benachbarten Zähnen kann auf das Innengewinde 32 abgestimmt sein. Beispielsweise kann ein Abstand zwischen den Zähnen 117, 118 so gewählt sein, dass er gleich der Ganghöhe des Innengewindes 32 ist. Die Zähne 117, 118 sind an den voneinander weg zeigenden Außenseiten der Klemmeinrichtung 110 ausgebildet, um die Befestigung der Klemmeinrichtung in dem Innengewinde 32 zu erlauben.

Die Kontaktierungseinrichtung 110 umfasst eine Druckfeder 116 oder ein anderes Druckelement, das den ersten Kontakt 111 und den zweiten Kontakt 112 federnd voneinander weg drückt. Im Gegensatz zu herkömmlichen Kelvinklemmen werden der erste Kontakt 111 und der zweite Kontakt 112 voneinander weg und nicht aufeinander zu vorgespannt.

Der erste Kontakt 111 und der zweite Kontakt 112 sind durch eine Halterung 115 mechanisch gekoppelt, aber elektrisch gegeneinander isoliert. Die Halterung 115 kann beispielsweise aus einem isolierenden Material bestehen oder ein isolierendes Material umfassen, um den ersten Kontakt 111 und den zweiten Kontakt 112 elektrisch voneinander zu isolieren.

Bei Verwendung der Klemmeinrichtung 110 werden der erste Kontakt 111 und der zweite Kontakt 112 in das Schraubloch 31 des Prüfobjekts 30 eingeführt. Die Druckfeder 116 drückt den ersten Kontakt 111 und den zweiten Kontakt 112 auseinander und drückt dadurch die Zähne 117, 118 gegen das Innengewinde 32 des Gewindelochs 31. Auch diese Klemmeinrichtung 110 kann auch bei Prüfobjekten verwendet werden, deren Anschlusspunkt kleine Abmessungen um das Gewindeloch 31 aufweist.

Bei den Kontaktierungseinrichtungen 10, 110 nach den verschiedenen Ausführungsbeispielen können der erste Kontakt und der zweite Kontakt jeweils aus einem geeigneten leitenden Material, beispielsweise Metall oder einer Metalllegierung, bestehen.

Für eine Widerstandsmessung kann eine Kontaktierungseinrichtung nach einem Ausführungsbeispiel in Kombination mit einer oder mehreren herkömmlichen Klemmen verwendet werden. Es können auch zwei Kontaktierungseinrichtungen nach Ausführungsbeispielen verwendet werden. Eine Kontaktierungseinrichtung dient dabei jeweils, um einen elektrischen Kontakt zum Einspeisen des Stroms und einen weiteren elektrischen Kontakt zum Abgreifen eines Potenzials für eine Spannungsmessung bereitzustellen.

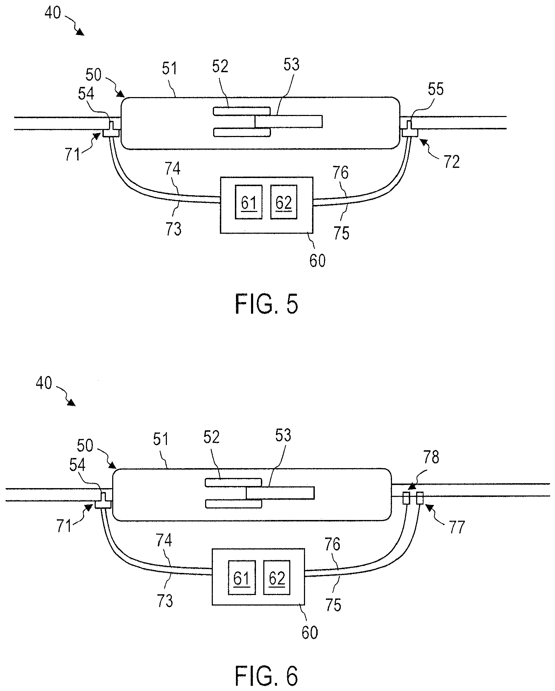

Figur 5 zeigt ein System 40 nach einem Ausführungsbeispiel. Das System 40 umfasst ein Prüfobjekt 50. Das Prüfobjekt kann ein Hochspannungsschalter sein. Das Prüfobjekt 50 kann eine andere Einrichtung für Hochspannungsnetze oder Mittelspannungsnetze sein. Das Prüfobjekt kann mehrere Elektroden 52, 53 umfassen, von denen wenigstens eine beweglich in einer Schalterkammer 51 gelagert sein kann.

Um einen Widerstand des Prüfobjekts 50, beispielsweise eines Schalters oder Trenners im geschlossenen Zustand, zu messen, kann ein Messgerät 60 des Systems für eine Widerstandsmessung nach der Vier-Punkt-Methode eingerichtet sein. Das Messgerät 60 kann eine Stromquelle 61 umfassen. Die Stromquelle 61 kann eingerichtet sein, um einen Strom von wenigstens 10 Ampere dem Prüfobjekt 50 aufzuprägen. Das Messgerät 60 kann eine Spannungsmesseinrichtung 62 umfassen.

Das Messgerät 60 kann für eine Widerstandsmessung über vier Leitungen mit dem Prüfobjekt 50 verbunden werden. Das Prüfobjekt 50 kann einen Anschlusspunkt mit einem Gewindeloch 54 und einen Anschlusspunkt mit einem weiteren Gewindeloch 55 umfassen. Das Gewindeloch 54 und das weitere Gewindeloch 55 können beispielsweise an unterschiedlichen Seiten des Stoßkontakts der Elektroden 52, 53 angeordnet sein.

Eine Kontaktierungseinrichtung 71 ist mechanisch mit dem Gewindeloch 54 gekoppelt, so dass der erste Kontakt und der zweite Kontakt der Kontaktierungseinrichtung 71 gegen das Prüfobjekt 50 gedrückt werden. Eine weitere Kontaktierungseinrichtung 72 ist mechanisch mit dem weiteren Gewindeloch 55 gekoppelt, so dass der erste Kontakt und der zweite Kontakt der weiteren Kontaktierungseinrichtung 72 gegen das Prüfobjekt 50 gedrückt werden. Die Kontaktierungseinrichtung 71 und die weitere Kontaktierungseinrichtung 72 können als Kontaktierungseinrichtung nach einem Ausführungsbeispiel ausgestaltet sein und beispielsweise jeweils eine der unter Bezugnahme auf Figur 1 bis Figur 4 beschriebenen Ausgestaltungen aufweisen.

Um einen Gleichstrom auf das Prüfobjekt 50 aufzuprägen, ist die Gleichstromquelle 61 über eine Leitung 73 mit dem ersten Kontakt der Kontaktierungseinrichtung 71 und über eine Leitung 75 mit dem ersten Kontakt der weiteren Kontaktierungseinrichtung 72 verbunden. Zur Spannungsmessung ist die Spannungsmesseinrichtung 62 über eine Leitung 74 mit dem zweiten Kontakt der Kontaktierungseinrichtung 71 und über eine Leitung 76 mit dem ersten Kontakt der weiteren Kontaktierungseinrichtung 72 verbunden.

Das Messgerät 60 kann eine Widerstandsmessung als Vier-Punkt-Messung ausführen. Dabei stellt die Kontaktierungseinrichtung 71 sowohl einen elektrischen Anschluss zum Aufprägen des Stroms als auch einen elektrischen Anschluss zum Erfassen eines Potenzials für die Spannungsmessung bereit. Die weitere Kontaktierungseinrichtung 72 stellt ebenfalls sowohl einen elektrischen Anschluss zum Aufprägen des Stroms als auch einen elektrischen Anschluss zum Erfassen eines Potenzials für die Spannungsmessung bereit.

Eine Kontaktierungseinrichtung nach einem Ausführungsbeispiel kann auch in Kombination mit herkömmlichen Kontaktklemmen verwendet werden, wie unter Bezugnahme auf Figur 6 näher beschrieben wird.

Figur 6 zeigt ein System 40 nach einem Ausführungsbeispiel. Das Prüfobjekt 50 weist nur einen Anschlusspunkt mit einem Gewindeloch 54 auf. Eine Kontaktierungseinrichtung 71 nach einem Ausführungsbeispiel ist mit dem Innengewinde des Gewindelochs 54 in mechanisch gekoppelt, so dass der erste Kontakt und der zweite Kontakt der Kontaktierungseinrichtung 71 gegen das Prüfobjekt 50 gedrückt werden. Auf der entgegengesetzten Seite des Stoßkontakts zwischen den Elektroden 52, 53 muss das Prüfobjekt 50 keinen weiteren Anschlusspunkt mit einem Gewindeloch aufweisen. Eine Anschlussklemme 77, die eine herkömmliche Ausgestaltung aufweisen kann, kann zusammen mit dem ersten Kontakt der Kontaktierungseinrichtung 71 zum Aufprägen des Stroms für eine Vier-Punkt-Messung verwendet werden. Eine weitere Eine Anschlussklemme 78, die eine herkömmliche Ausgestaltung aufweisen kann, kann zusammen mit dem zweiten Kontakt der Kontaktierungseinrichtung 71 zur Spannungsmessung für eine Vier-Punkt-Messung verwendet werden.

Während Ausführungsbeispiele unter Bezugnahme auf die Figuren detailliert beschrieben wurden, können bei weiteren Ausführungsbeispielen alternative oder zusätzliche Merkmale verwendet werde. Während beispielsweise Kontaktierungseinrichtungen nach Ausführungsbeispielen für Mikroohmmessungen verwendet werden können, können die Kontaktierungseinrichtungen auch für andere Widerstandsmessungen eingesetzt werden.

Während Kontaktierungseinrichtungen, Systeme und Verfahren nach Ausführungsbeispielen bei Hochspannungsschaltern oder anderen Einrichtungen für Hochspannungs- oder Mittelspannungsnetze verwendet werden können, können sie auch in Kombination mit anderen elektrischen Einheiten eingesetzt werden. Die Kontaktierungseinrichtungen können bei einer Qualitätsprüfung beispielsweise nach der Fertigung und vor der Auslieferung oder bei einer Überprüfung im installierten Zustand verwendet werden. Falls der Anschlusspunkt mit dem Gewindeloch im Nutzbetrieb mit einem anderen Leiter verbunden ist, kann die Kontaktierungseinrichtung vorübergehend mit dem Anschlusspunkt gekoppelt werden, bis die Widerstandsmessung abgeschlossen ist.

Kontaktierungseinrichtungen, Systeme und Verfahren und Systeme nach Ausführungsbeispielen erlauben die einfache und zuverlässige elektrische Kontaktierung von Anschlusspunkten, die ein Gewindeloch aufweisen.

## Patentansprüche

1. System, umfassend
ein Messgerät (60), das zum Ausführen einer Widerstandsmessung mittels einer Vier-Punkt-Messung eingerichtet ist, und
eine Kontaktierungseinrichtung (10; 110; 71) und eine weitere Kontaktierungseinrichtung (72) zum elektrischen Kontaktieren eines Prüfobjekts (30; 50), das ein Gewindeloch (31; 54, 55), welches ein Innengewinde (32) aufweist, umfasst,
wobei jede Kontaktierungseinrichtung (10; 110; 71, 72) für eine mechanische Kopplung mit dem Innengewinde (32) des Gewindelochs (31; 54, 55) eingerichtet ist,
wobei jede Kontaktierungseinrichtung (10; 110; 71, 72) einen ersten Kontakt (11; 111) und einen zweiten Kontakt (12; 112) umfasst, um das Prüfobjekt (30; 50) an wenigstens zwei Stellen elektrisch zu kontaktieren, wenn die Kontaktierungseinrichtung (10; 110; 71, 72) mit dem Innengewinde (32) des Gewindelochs (31; 54, 55) mechanisch gekoppelt ist,
wobei der erste Kontakt (11) und der zweite Kontakt (12) in jeder Kontaktierungseinrichtung (10; 110; 71, 72) durch ein isolierendes Material (15-17; 18) elektrisch voneinander isoliert sind, und
wobei der erste Kontakt (11; 111) und der zweite Kontakt (12; 112) jeder Kontaktierungseinrichtung (72) elektrisch leitend mit dem Messgerät (60) verbunden sind.

2. System nach Anspruch 1,
wobei jede Kontaktierungseinrichtung (10; 71, 72) einen Schraubenabschnitt (19) aufweist, der in das Gewindeloch (31; 54, 55) des Prüfobjekts (30; 50) einschraubbar ist,
wobei der Schraubenabschnitt ein Außengewinde aufweist, das für einen Gewindeeingriff mit dem Gewindeloch (31; 54, 55) des Prüfobjekts (30; 50) ausgestaltet ist.

3. System nach Anspruch 2,
wobei der erste Kontakt (11) und der zweite Kontakt (12) in jeder Kontaktierungseinrichtung (10; 71, 72) elektrisch von dem Schraubenabschnitt (19) isoliert sind.

4. System nach einem der Ansprüche 2 bis 3,
wobei der erste Kontakt (11) und der zweite Kontakt (12) so an jeder Kontaktierungseinrichtung (10; 71, 72) angeordnet sind, dass sie von einer Innenoberfläche des Gewindelochs (31; 54, 55) beabstandet sind, wenn die jeweilige Kontaktierungseinrichtung (10; 110; 71, 72) mit dem Innengewinde (32) des Gewindelochs (31; 54, 55) mechanisch gekoppelt ist.

5. System nach Anspruch 2,
wobei der erste Kontakt (11) den Schraubenabschnitt (19) bildet, und
wobei der zweite Kontakt (12) so an jeder Kontaktierungseinrichtung (10; 71, 72) angeordnet ist, dass er von einer Innenoberfläche des Gewindelochs (31; 54, 55) beabstandet ist, wenn die jeweilige Kontaktierungseinrichtung (10; 71, 72) mit dem Innengewinde (32) des Gewindelochs (31; 54, 55) mechanisch gekoppelt ist.

6. System nach Anspruch 2,
wobei der Schraubenabschnitt sowohl den ersten Kontakt (11) als auch den zweiten Kontakt (12) umfasst.

7. System nach Anspruch 6,
wobei der erste Kontakt (11) einen Abschnitt (25) wenigstens eines Gewindegangs und der zweite Kontakt (12) einen weiteren Abschnitt (26) des wenigstens einen Gewindegangs aufweist.

8. System nach Anspruch 6 oder Anspruch 7,
wobei der Schraubenabschnitt durch das elektrisch isolierende Material (18) in den ersten Kontakt (11) und den zweiten Kontakt (12) unterteilt ist.

9. System nach Anspruch 1,
wobei wenigstens einer von dem ersten Kontakt (111) und dem zweiten Kontakt (112) ein gefederter Kontakt ist.

10. System nach Anspruch 9,
wobei jede Kontaktierungseinrichtung (110; 71, 72) ein Druckelement (116) umfasst, das den ersten Kontakt (111) und den zweiten Kontakt (112) federnd voneinander weg drückt.

11. System nach einem der Ansprüche 9 bis 10,
wobei der erste Kontakt (111) und der zweite Kontakt (112) so angeordnet sind, dass sie unterschiedliche Bereiche einer Innenoberfläche des Innengewindes (32) des Gewindelochs (31; 54, 55) elektrisch kontaktieren, wenn die jeweilige Kontaktierungseinrichtung (110; 71, 72) mit dem Innengewinde (32) des Gewindelochs (31; 54, 55) mechanisch gekoppelt ist.

12. System nach einem der Ansprüche 1-11,
wobei jede Kontaktierungseinrichtung (10; 110; 71) mechanisch mit dem Innengewinde (32) des Prüfobjekts (30; 50) koppelbar ist.

13. System nach Anspruch 12,
wobei das Prüfobjekt (30; 50) ein Hochspannungsschalter ist.

14. Verfahren zum elektrischen Kontaktieren eines Prüfobjekts (30; 50) für eine Widerstandsmessung, wobei das Prüfobjekt (30; 50) ein Gewindeloch (31; 54, 55), welches ein Innengewinde (32) aufweist, umfasst,
wobei das Verfahren umfasst:
Herstellen einer mechanischen Kopplung zwischen einer Kontaktierungseinrichtung (10; 110; 71, 72) und dem Innengewinde (32) des Gewindelochs (31; 54, 55), um das Prüfobjekt (30; 50) für die Widerstandsmessung mit einem ersten Kontakt der Kontaktierungseinrichtung (10; 110; 71, 72) und mit einem zweiten Kontakt der Kontaktierungseinrichtung (10; 110; 71, 72) an wenigstens zwei Stellen elektrisch zu kontaktieren, wobei der erste Kontakt (11; 111) und der zweite Kontakt (12; 112) in der Kontaktierungseinrichtung (10; 110; 71, 72) durch ein elektrisch isolierendes Material (15-17; 18) elektrisch voneinander isoliert sind,
**dadurch gekennzeichnet,**
**dass** über den ersten Kontakt (11; 111) ein Strom in das Prüfobjekt (30; 50) eingeprägt wird und wobei der zweite Kontakt (12; 112) für eine Spannungsmessung verwendet wird.

15. Verfahren nach Anspruch 14,
wobei das Verfahren mit einem System nach einem der Ansprüche 1-13 durchgeführt wird.

## Claims

1. A system, comprising
a measuring device (60) configured to perform a resistance measurement by means of a four-point measurement, and
a contact-making device (10; 110; 71) and a further contact-making device (72) for making electrical contact with a test object (30; 50) that comprises a threaded hole (31; 54, 55) which has an internal thread (32),
wherein each contact-making device (10; 110; 71, 72) is configured for mechanical coupling to the internal thread (32) of the threaded hole (31; 54, 55), wherein each contact-making device (10; 110; 71, 72) comprises a first contact (11; 111) and a second contact (12; 112) for making electrical contact with the test object (30; 50) at at least two points, when the contact-making device (10; 110; 71, 72) is mechanically coupled to the internal thread (32) of the threaded hole (31; 54, 55),
wherein the first contact (11) and the second contact (12) are electrically insulated from one another by an insulating material (15-17; 18) in each contact-making device (10; 110; 71, 72), and
wherein the first contact (11; 111) and the second contact (12; 112) of each contact-making device (10; 110; 71, 72) have an electrically conductive connection to the measuring device (60).

2. The system according to claim 1,
wherein each contact-making device (10; 71, 72) has a threaded portion (19), which can be screwed into the threaded hole (31; 54, 55) of the test object (30; 50),
wherein the threaded portion has an external thread configured for a thread engagement with the threaded hole (31; 54, 55) of the test object (30; 50).

3. The system according to claim 2,
wherein the first contact (11) and the second contact (12) are electrically insulated from the threaded portion (19) in each contact-making device (10; 71, 72).

4. The system according to any one of claims 2 to 3,
wherein the first contact (11) and the second contact (12) are arranged on each contact-making device (10; 71, 72) so that they are spaced apart from an internal surface of the threaded hole (31; 54, 55), when the respective contact-making device (10; 110; 71, 72) is mechanically coupled to the internal thread (32) of the threaded hole (31; 54, 55).

5. The system according to claim 2,
wherein the first contact (11) forms the threaded portion (19), and
wherein the second contact (12) is arranged on each contact-making device (10; 71, 72) so that it is spaced apart from an internal surface of the threaded hole (31; 54, 55), when the respective contact-making device (10; 71, 72) is mechanically coupled to the internal thread (32) of the threaded hole (31; 54, 55).

6. The system according to claim 2,
wherein the threaded portion comprises both the first contact (11) and the second contact (12).

7. The system according to claim 6,
wherein the first contact (11) has a portion (25) of at least one thread turn and the second contact (12) has a further portion (26) of the at least one thread turn.

8. The system according to claim 6 or claim 7,
wherein the threaded portion is divided into the first contact (11) and the second contact (12) by the electrically insulating material (18).

9. The system according to claim 1,
wherein at least one of the first contact (111) and the second contact (112) is a spring-loaded contact.

10. The system according to claim 9,
wherein each contact-making device (110; 71, 72) comprises a pressure element (116), which pushes the first contact (111) and the second contact (112) away from one another in a springy manner.

11. The system according to any one of claims 9 to 10,
wherein the first contact (111) and the second contact (112) are arranged so that they make electrical contact with different areas of an internal surface of the internal thread (32) of the threaded hole (31; 54, 55), when the respective contact-making device (110; 71, 72) is mechanically coupled to the internal thread (32) of the threaded hole (31; 54, 55).

12. The system according to any one of claims 1-11,
wherein each contact-making device (10; 110; 71) can be mechanically coupled to the internal thread (32) of the test object (30; 50).

13. The system according to claim 12,
wherein the test object (30; 50) is a high-voltage switch.

14. A method for making electrical contact with a test object (30; 50) for a resistance measurement, wherein the test object (30; 50) comprises a threaded hole (31; 54, 55) having an internal thread (32),
wherein the method comprises:
establishing a mechanical coupling between a contact-making device (10; 110; 71, 72) and the internal thread (32) of the threaded hole (31; 54, 55) in order to make electrical contact for the resistance measurement with the test object (30; 50) by means of a first contact of the contact-making device (10; 110; 71, 72) and a second contact of the contact-making device (10; 110; 71, 72) at at least, two points, wherein the first contact (11; 111) and the second contact (12; 112) are electrically insulated from one another in the contact-making device (10; 110; 71, 72) by an electrically insulating material (15-17; 18),
**characterized in that**
a current is impressed in the test object (30; 50) via the first contact (11; 111) and the second contact (12; 112) is used for a voltage measurement.

15. The method according to claim 14,
wherein the method is carried out with a system according to any one of claims 1-13..

## Revendications

1. Système, comprenant
un appareil de mesure (60) qui est conçu pour effectuer une mesure de résistance au moyen d'une mesure en quatre points, et
un dispositif d'établissement de contact (10 ; 110 ; 71) et un dispositif d'établissement de contact (72) supplémentaire destiné à établir un contact électrique avec un objet à tester (30 ; 50) qui comprend un trou fileté (31 ; 54, 55) présentant un filetage intérieur (32),
dans lequel chaque dispositif d'établissement de contact (10 ; 110 ; 71, 72) est conçu pour un couplage mécanique au filetage intérieur (32) du trou fileté (31 ; 54, 55),
dans lequel chaque dispositif d'établissement de contact (10 ; 110 ; 71, 72) comprend un premier contact (11 ; 111) et un second contact (12 ; 112) pour établir un contact électrique avec l'objet à tester (30 ; 50) en au moins deux endroits lorsque le dispositif d'établissement de contact (10; 110; 71, 72) est couplé mécaniquement au filetage intérieur (32) du trou fileté (31 ; 54, 55),
dans lequel le premier contact (11) et le second contact (12) sont isolés électriquement l'un de l'autre dans chaque dispositif d'établissement de contact (10 ; 110 ; 71, 72) grâce à un matériau isolant (15 à 17 ; 18), et
dans lequel le premier contact (11 ; 111) et le second contact (12 ; 112) de chaque dispositif d'établissement de contact (72) sont reliés de manière électriquement conductrice à l'appareil de mesure (60).

2. Système selon la revendication 1,
dans lequel chaque dispositif d'établissement de contact (10 ; 71, 72) présente une section formant vis (19) qui peut être vissée dans le trou fileté (31 ; 54, 55) de l'objet à tester (30 ; 50),
dans lequel la section formant vis présente un filetage extérieur qui est configuré pour une mise en prise de filetage avec le trou fileté (31 ; 54, 55) de l'objet à tester (30 ; 50).

3. Système selon la revendication 2,
dans lequel le premier contact (11) et le second contact (12) sont isolés électriquement de la section formant vis (19) dans chaque dispositif d'établissement de contact (10 ; 71, 72)

4. Système selon l'une quelconque des revendications 2 à 3,
dans lequel le premier contact (11) et le second contact (12) sont agencés au niveau de chaque dispositif d'établissement de contact (10 ; 71, 72) de sorte qu'ils sont espacés par rapport à une surface intérieure du trou fileté (31 ; 54, 55) lorsque le dispositif d'établissement de contact (10 ; 110 ; 71, 72) respectif est couplé mécaniquement au filetage intérieur (32) du trou fileté (31 ; 54, 55).

5. Système selon la revendication 2,
dans lequel le premier contact (11) forme la section formant vis (19), et
dans lequel le second contact (12) est agencé au niveau de chaque dispositif d'établissement de contact (10 ; 71, 72) de sorte qu'il est espacé par rapport à une surface intérieure du trou fileté (31 ; 54, 55) lorsque le dispositif d'établissement de contact (10 ; 71, 72) respectif est couplé mécaniquement au filetage intérieur (32) du trou fileté (31 ; 54, 55)

6. Système selon la revendication 2,
dans lequel la section formant vis comprend aussi bien le premier contact (11) que le second contact (12).

7. Système selon la revendication 6,
dans lequel le premier contact (11) présente une section (25) d'au moins un pas de vis et le second contact (12) présente une autre section (26) de l'au moins un pas de vis.

8. Système selon la revendication 6 ou la revendication 7,
dans lequel la section formant vis est divisée grâce au matériau électriquement isolant (18) de manière à fournir le premier contact (11) et le second contact (12).

9. Système selon la revendication 1,
dans lequel au moins un parmi le premier contact (111) et le second contact (112) est un contact sur ressort.

10. Système selon la revendication 9,
dans lequel chaque dispositif d'établissement de contact (110 ; 71, 72) comprend un élément de pression (116) qui pousse de manière résiliente le premier contact (111) et le second contact (112) en les éloignant l'un de l'autre.

11. Système selon l'une quelconque des revendications 9 à 10,
dans lequel le premier contact (111) et le second contact (112) sont agencés de sorte qu'ils viennent en contact électrique avec différentes régions d'une surface intérieure du filetage intérieur (32) du trou fileté (31 ; 54, 55) lorsque le dispositif d'établissement de contact (110; 71, 72) respectif est couplé mécaniquement au filetage intérieur (32) du trou fileté (31 ; 54, 55).

12. Système selon l'une quelconque des revendications 1 à 11,
dans lequel chaque dispositif d'établissement de contact (10 ; 110 ; 71) peut être couplé mécaniquement au filetage intérieur (32) de l'objet à tester (30 ; 50).

13. Système selon la revendication 12,
dans lequel l'objet à tester (30 ; 50) est un interrupteur haute tension.

14. Procédé pour établir un contact électrique avec un objet à tester (30 ; 50) pour une mesure de résistance, dans lequel l'objet à tester (30 ; 50) comprend un trou fileté (31 ; 54, 55) qui présente un filetage intérieur (32),
dans lequel le procédé comprend :
la création d'un couplage mécanique entre un dispositif d'établissement de contact (10 ; 110 ; 71, 72) et le filetage intérieur (32) du trou fileté (31 ; 54, 55) pour établir un contact électrique entre l'objet à tester (30 ; 50) pour la mesure de résistance et un premier contact du dispositif d'établissement de contact (10 ; 110 ; 71, 72) et un second contact du dispositif d'établissement de contact (10; 110; 71, 72) en au moins deux endroits, dans lequel le premier contact (11 ; 111) et le second contact (12 ; 112) sont isolés électriquement l'un de l'autre dans le dispositif d'établissement de contact (10 ; 110 ; 71, 72) grâce à un matériau électriquement isolant (15 à 17 ; 18),
**caractérisé en ce que**
un courant électrique est appliqué dans l'objet à tester (30 ; 50) par l'intermédiaire du premier contact (11 ; 111) et dans lequel le second contact (12 ; 112) est utilisé pour une mesure de tension.

15. Procédé selon la revendication 14
dans lequel le procédé est mis en œuvre avec un système selon l'une quelconque des revendications 1 à 13.
